# EUROPEAN PATENT APPLICATION

(11) **EP 4 769 885 A1**
(43) Date of publication of application: **01.07.2026**
(21) Application number: 25857200.7
(22) Date of filing: 16.07.2025
(51) Int. Cl.: H02J 7/00, G01R 31/382, G01R 31/396

(54) **APPARATUS AND METHOD FOR CONTROLLING BATTERY**

(30) Priority: 23.08.2024 KR 20240113257
(71) Applicant: LG Energy Solution Ltd., Seoul 07335 (KR)
(72) Inventor: KANG, Woo Sung, Daejeon 34122 (KR)
(74) Representative: Goddar, Heinz J.
(86) International application number: PCT/KR2025/010435
(87) International publication number: WO 2026/043113

(57) **Abstract**

An apparatus for controlling a battery according to an embodiment of the present invention controls a battery system in which a plurality of battery packs are connected in parallel, and may comprise: a self discharging circuit unit connected in parallel with the plurality of battery packs; and a control unit that measures a current flowing through each battery pack when each battery pack is started according to a use request for the plurality of battery packs, and controls the self discharging circuit unit to be turned on according to the current flowing through the battery pack.

## Description

This application claims priority to and the benefit of Korean Patent Application No.10-2024-0113257 filed in the Korean Intellectual Property Office on August 23, 2024 the entire contents of which are incorporated herein by reference.

The present disclosure relates to a battery control apparatus and method, and more particularly, to a battery control apparatus and method for controlling a battery using self discharge circuit.

### [Background]

Secondary batteries, capable of recharging and reuse, may be used as an energy source for small devices such as mobile phones, tablet PCs and vacuum cleaners, and also used as an energy source for medium and large devices such as automobiles and an energy storage system (ESS) for smart grids.

Secondary batteries may be applied to a system in a form of an assembly such as a battery assembly in which a plurality of battery cells are electrically connected or a battery pack in which battery assemblies are connected in serial and/or parallel according to system requirements. For medium to large-sized devices such as electric vehicles, a high-capacity battery system with a plurality of battery packs connected in parallel can be applied to satisfy required capacity of the corresponding device.

A battery pack is a structure composed of a plurality of battery cells, and thus, overvoltage, overcurrent, and overheating in certain battery cells can compromise the safety and operational efficiency of the battery pack, making detection methods essential. Therefore, battery packs are usually equipped with a Battery Management System (BMS), which measures the voltage of each battery cell and monitors and controls its voltage state based on these measurements.

Meanwhile, lithium-ion batteries, one of the most widely used batteries, have a safe operation range based on temperature and the allowable charge temperature range and allowable discharge temperature range differ. Lithium-ion battery packs perform a safety action by opening a relay in the battery pack if current flows outside the safe operation range.

However, if battery use (i.e., discharging) is requested in a temperature range where discharging is permitted but charging is not, a problem arises where the battery pack becomes unusable due to unintentional charging current temporarily flowing within the pack.

### [SUMMARY]

To obviate one or more problems of the related art, embodiments of the present disclosure provide a battery control apparatus for detecting a battery pack through which a charging current flows and controlling a discharging current to flow using a self-discharge circuit, thereby supporting more stable battery use.

To obviate one or more problems of the related art, embodiments of the present disclosure also provide a battery control method performed by the battery control apparatus.

In order to achieve the objective of the present disclosure, a battery control apparatus, for controlling a battery system in which a plurality of battery packs are connected in parallel, may include a self-discharge circuit connected in parallel with the plurality of battery packs; and a controller configured to measure a current flowing through each battery pack when each battery pack starts operating in response to a request for use of the plurality of battery packs and to control turning on the self-discharge circuit based on the current flowing through the battery pack.

The controller may turn on the self-discharge circuit when a charging current is generated in one or more of the plurality of battery packs while the temperature of the plurality of battery packs is outside an allowable charge temperature range.

A current, offsetting the charging current flowing through the battery pack, may be generated when a switch within the self-discharge circuit is turned on by the controller.

The current offsetting the charging current may be a current in the opposite direction to the charging current flowing in the battery pack.

Upon turning on the self-discharge circuit, the current flow in the battery pack which a charging current has been flowing may be changed to cause a discharging current to flow in the battery pack.

The current offsetting the charging current, which is generated by turning on the self-discharge circuit, may be equal to the sum of the discharge currents flowing in the plurality of battery packs.

Each battery pack may include one or more cell assemblies including a plurality of cells; a high-voltage relay connected to the one or more cell assemblies; and a pack battery management apparatus configured to manage the one or more cell assemblies.

The controller may be included in a master battery management apparatus which is connected with a plurality of pack battery management apparatuses for the plurality of battery packs and configured to manage the plurality of pack battery management apparatuses.

The self-discharge circuit may include one or more switches and one or more resistor elements and the switches and the resistor elements may be connected in series.

According to another embodiment of the present disclosure, a method of controlling a battery system, in which a plurality of battery packs are connected in parallel, may include determining if each battery pack starts operating in response to a request for use of the plurality of battery packs; measuring a current flowing through each battery pack; and controlling the self-discharge circuit to be turned on based on the current flowing through the battery pack.

The controlling the self-discharge circuit to be turned on may include turning on the self-discharge circuit when a charging current is generated in one or more of the plurality of battery packs while the temperature of the plurality of battery packs is outside an allowable charge temperature range.

A current, offsetting the charging current flowing through the battery pack, may be generated when a switch within the self-discharge circuit is turned on by the controller.

The current offsetting the charging current may be a current in the opposite direction to the charging current flowing in the battery pack.

Upon turning on the self-discharge circuit, the current flow in the battery pack which a charging current has been flowing may be changed to cause a discharging current to flow in the battery pack.

The current offsetting the charging current, which is generated by turning on the self-discharge circuit, may be equal to the sum of the discharge currents flowing in the plurality of battery packs.

Each battery pack may include one or more cell assemblies including a plurality of cells; a high-voltage relay connected to the one or more cell assemblies; and a pack battery management apparatus configured to manage the one or more cell assemblies.

The self-discharge circuit may include one or more switches and one or more resistor elements and the switches and the resistor elements may be connected in series.

The controlling of the self-discharge circuit to be turned on based on the current flowing through the battery pack may include determining whether the maximum value among the measured current values is positive; determining whether the temperature of the battery pack is within an allowable charge temperature range; and turning on the self-discharge circuit if the maximum value is positive and the temperature of the battery pack is outside the allowable charge temperature range.

The determining if each battery pack starts operating may include determining whether a battery has woken up in response to a request for use of the plurality of battery packs; and determining whether a relay included in each battery pack has been switched to a closed state.

According to embodiments of the present disclosure, charging current can be prevented from flowing outside the allowable charge temperature range of a lithium-ion battery.

Furthermore, the problem of battery system being unusable due to unintended safety operation that can occur due to a mismatch between the battery discharge and charge temperature ranges can be resolved.

Therefore, the battery system can be used more stably.

### [Brief Description of the Drawings]

FIG. 1 is a block diagram of a battery system structure to which embodiments of the present disclosure can be applied.
FIG. 2 is a block diagram of a battery pack to which the present disclosure can be applied.
FIG. 3 is a diagram of the current flow generated in each pack within a parallel battery system.
FIG. 4 is graph of the respective discharge and charge currents that can be generated in each pack.
FIG. 5 is a block diagram of a battery system according to embodiments of the present disclosure.
FIG. 6 is a graph of the current pattern that can be generated in each pack when an offset current flows in, according to embodiments of the present disclosure.
FIG. 7 is a flowchart illustrating battery control operations that can be performed by a battery control apparatus according to embodiments of the present disclosure.

10, 10-1, 10-2, 10-3: Battery pack
20: Load
100: Cell assembly
300: Pack BMS
310: Master BMS
500: Protection assembly
700: Self-discharge circuit
710: Switch
720: Resistor

### DETAILED DISCLOSURE

The present disclosure may be modified in various forms and have various embodiments, and specific embodiments thereof are shown by way of example in the drawings and will be described in detail below. It should be understood, however, that there is no intent to limit the present disclosure to the specific embodiments, but on the contrary, the present disclosure is to cover all modifications, equivalents, and alternatives falling within the spirit and technical scope of the present disclosure. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present disclosure. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present disclosure belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Hereinafter, exemplary embodiments of the present disclosure will be described in detail with reference to the accompanying drawings.

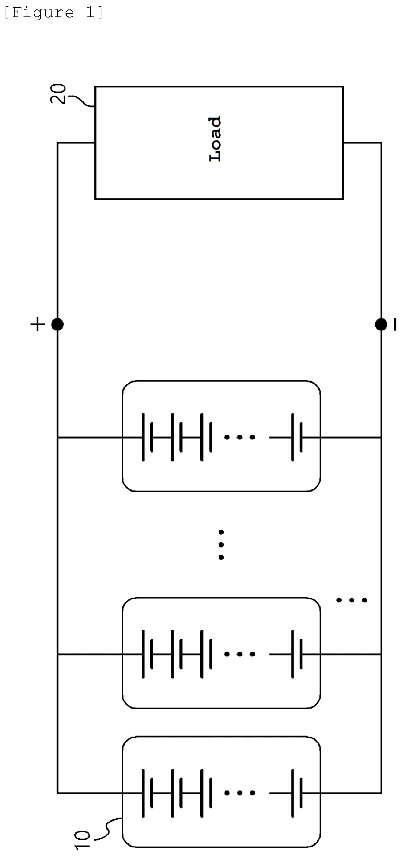

FIG. 1 illustrates an example of a battery system structure to which embodiments of the present disclosure can be applied.

Due to the trend toward electrification of commercial vehicles and trucks, the use of high-capacity batteries is increasing. To meet these high-capacity specifications, a battery system of parallel pack structure, as illustrated in FIG. 1, can be used.

Referring to FIG. 1, the battery system considered in the embodiment of the present disclosure may include a plurality of battery packs 10 connected in parallel. Each battery pack may comprise a plurality of battery cells connected in series and parallel. A battery cell is the basic unit for storing power. The battery cell may be a lithium-ion (Li-Ion) battery cell.

Battery packs 10 connected in parallel are connected to a load 20 through positive and negative terminals and may perform charge/discharge operations. The load 20 may include any other components within the electric vehicle, such as an inverter. Each battery pack 10 may include one or more cell assemblies, a high-voltage relay, and a battery management apparatus. Each cell assembly may comprise a plurality of cells connected in series and parallel, as well as a temperature sensor.

Meanwhile, lithium-ion batteries have an allowable discharge temperature range which is different from an allowable charge temperature, which may cause a problem when using the batteries at certain temperatures when lithium-ion batteries are configured in a parallel pack form.

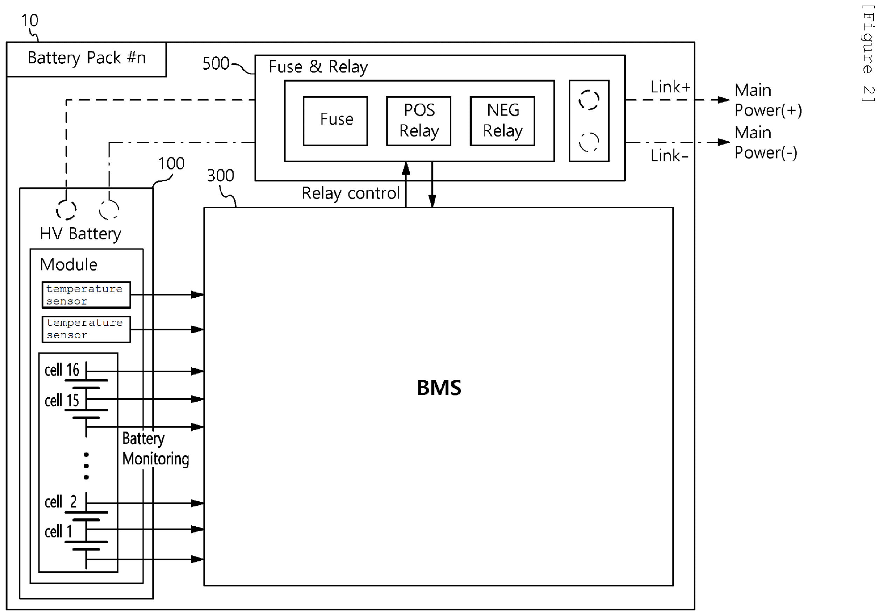

FIG. 2 is a block diagram of a battery pack 10 to which the present disclosure can be applied.

Referring to FIG. 2, an individual battery pack 10 may include a cell assembly 100, a battery management apparatus 300, and a protection assembly 500.

More specifically, the cell assembly 100 may include a plurality of cells connected in series and parallel, a plurality of temperature sensors, and the like. Furthermore, the protection assembly 500 may include one or more fuses, a positive relay connected to the positive terminal of the cell assembly, and a negative relay connected to the negative terminal of the cell assembly. Whether the output of the corresponding battery pack 10 is transmitted to the load 20 may be determined based on whether the relays within the protection assembly 500 are open or closed.

Each battery pack 10 may include a pack BMS 300, which monitors the current, voltage, and temperature of each battery pack under its control and may perform battery diagnosis. As a result of the diagnosis, if the temperature of the pack is outside the allowable discharge or charge temperature during charging and discharging, i.e., while current is flowing, and is thus high (over temperature) or low (under temperature), the positive and negative relays within the protection assembly 500 may be turned off. Furthermore, if the diagnosis determines that overcurrent is flowing during charging and discharging, i.e., in the case of overpower, the positive and negative relays within the protection assembly 500 may be turned off.

Meanwhile, the pack BMS 300 may include various components such as fuses, current sensing elements, thermistors, switches, and balancers for monitoring and diagnosis. Most of them include a Micro Controller Unit (MCU) or a Battery Monitoring Integrated Chip (BMIC) for interfacing and controlling these components. The BMIC may be an IC-type component located within the BMS that measures information such as voltage, temperature, and current of the battery cell/assembly.

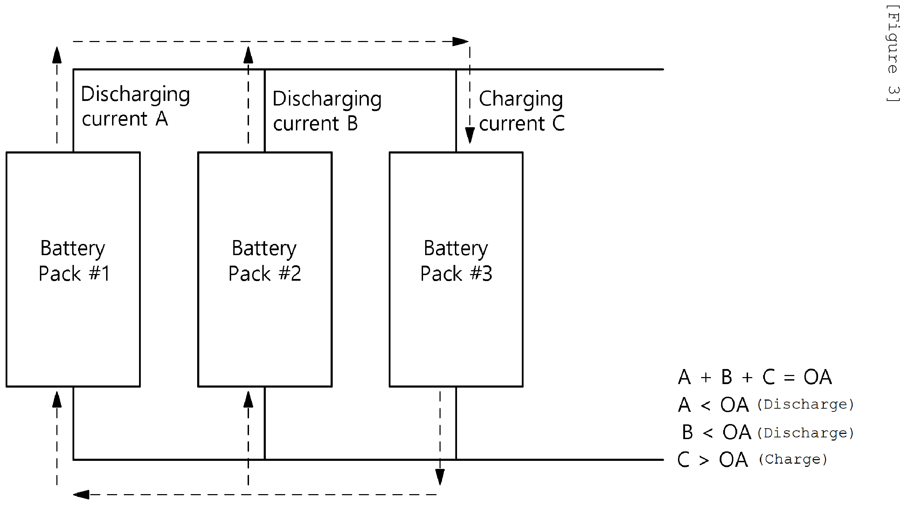

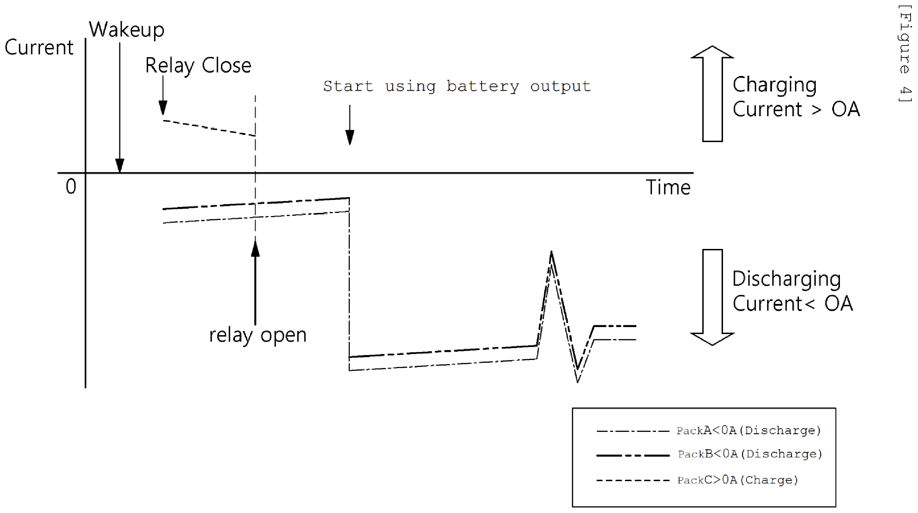

FIG. 3 illustrates the current flow generated in each pack within a parallel battery system and FIG. 4 illustrates the respective discharge and charge currents generated in each pack.

FIGS. 3 and 4 illustrate potential battery usage issues that may arise due to differences in the allowable discharge temperature and allowable charge temperature in a parallel battery system using lithium-ion batteries.

Lithium-ion batteries have a safe operating range depending on temperature, and the allowable charge temperature range differs from the allowable discharge temperature range. For example, if the allowable charge temperature is 0°C to 55°C, the allowable discharge temperature is determined to -20°C to 65°C. For another example, the allowable discharge temperature range for a low-temperature lithium battery is -40°C to 60°C whereas the allowable charge temperature range is 0°C to 45°C. Furthermore, when the allowable discharge temperature range for a high-temperature lithium battery is -20°C to 80°C, the allowable charge temperature range may be 0°C to 50°C. Thus, while the allowable charge temperature range and allowable discharge temperature range may vary depending on the type (model) of the lithium-ion battery, it is understood that there exist differences between the allowable charge and discharge temperature ranges, and generally, the allowable charge temperature range is more limited than the allowable discharge temperature range.

Meanwhile, before the high-voltage relay is closed and the battery output is used by a load (i.e., even without using an external load), the potential difference between packs may cause current to flow in the discharge direction in some packs, while current flows in the charge direction in others. Here, the discharge current value is negative (< 0 A), as shown in FIG. 4, and the charge current value is positive (> 0 A).

In other words, as shown in FIG. 3, when discharge current (discharge current A and discharge current B) flows through Battery Pack 1 and Battery Pack 2, charge current (charge current C) flows through Battery Pack 3 which has a lower potential than those of Battery Pack 1 and Battery Pack 2. Here, since battery packs 1, 2, and 3 are not yet connected to a load, the sum of discharge current A, discharge current B, and charging current is 0. Here, the pack (battery pack C) through which the charge current is flowing may be diagnosed that current is flowing under a condition that is outside the safe operation range, and thus, its relays are controlled to be open and the use of the battery is restricted.

Comparing the currents flowing through each battery pack using the graph in FIG. 4, when the battery management apparatus for battery use is turned on and the batteries begin to wake up, the relays for each battery pack are transitioned to a closed state. While not yet connected to a load, the potential difference between the packs causes a negative discharge current to flow through packs 1 and 2, while a positive charge current flows through pack 3.

Here, if the temperature of the battery is, for example, -10 degrees, in other words, if it is within the discharge allowable temperature range but not within the charge allowable temperature range, a safety action occurs in which the relay of battery pack 3 through which the charge current flows is controlled to open. After that point, the current flowing through battery pack 3 is "0", and accordingly, even when the battery output is connected to the load and the battery use is initiated, the output of battery pack 3 is not transmitted to the load. In other words, although discharging is intended, a problem occurs in which battery pack 3 cannot be used.

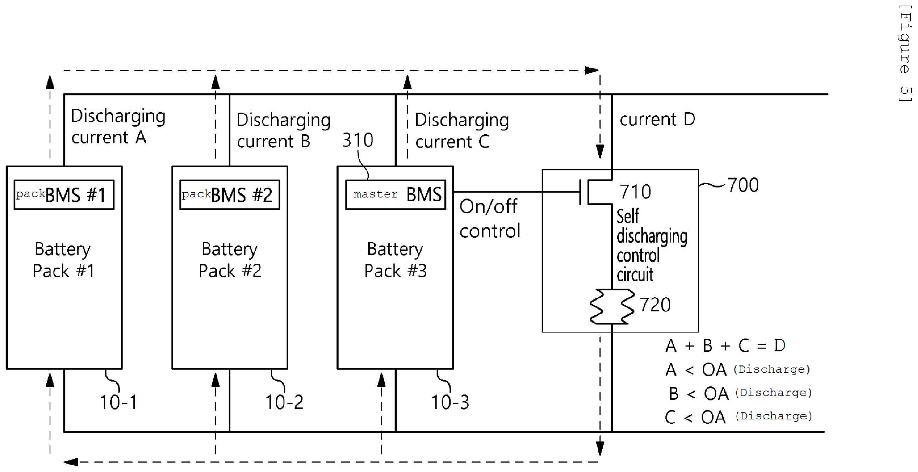

FIG. 5 is a block diagram of a battery system according to embodiments of the present disclosure.

In the battery system according to embodiments of the present disclosure, a plurality of battery packs 10-1, 10-2, 10-3 are connected in parallel, and each battery pack may include a battery management system (pack BMS). One of the plurality of pack BMSs may be a master BMS. The master BMS may not only function as a BMS for the corresponding pack, but also report measurement data collected from the pack BMSs of other battery packs to a higher-level system. In addition, the master BMS may monitor and control the plurality of pack BMSs in conjunction with the higher-level system.

A battery control apparatus according to embodiments of the present disclosure that controls such a battery system may include a self-discharge circuit 700 connected in parallel with the plurality of battery packs and a controller for controlling the self-discharge circuit. In the present disclosure, the controller may be a master BMS 310.

The controller 310 may measure the current flowing through each battery pack when a load is connected to each battery pack upon a request for use of a plurality of battery packs and control the self-discharge circuit to turn on based on the direction of the current flowing through the battery pack.

More specifically, the controller may control the self-discharge circuit to turn on when a charging current is generated in at least one of the plurality of battery packs. Under the control of the controller, a switch within the self-discharge circuit is turned on, generating an offset current corresponding to the charging current flowing through the battery pack.

Referring to FIG. 5, the offset current D may be in the opposite direction to the charging current flowing through the battery pack, i.e., the same direction as the discharging current. Accordingly, by turning on the self-discharge circuit, the current flow in the battery pack where the charging current (charging current C in FIG. 3) was flowing is changed, resulting in the discharge current (discharge current C in FIG. 5) flowing through the corresponding battery pack.

Here, the self-discharge circuit 700 may include a switch 710 and one or more resistor elements 720. The switch 710 may be implemented, for example, as a Field Effect Transistor (FET). The switch 710 allows a current that induces discharge to flow through the self-discharge circuit. The resistor element 720 can be connected in series with the switch 710 to prevent a short circuit in the corresponding circuit. A resistor element can be selected that can withstand the maximum power and energy that may be generated when the current that induces discharge flows through the self-discharge circuit 700.

The offset current generated by turning on the self-discharge circuit is equal to the sum of the discharge currents flowing through the plurality of battery packs. In other words, in FIG. 5, after the offset current is introduced, the sum of the discharge current (A) flowing through battery pack 1, the discharge current (B) flowing through battery pack 2, and the discharge current (C) flowing through battery pack 3 is equal to the current flowing through the self-discharge circuit 700.

Meanwhile, the controller may exist as hardware separate from the battery pack or may be incorporated into the master BMS 310. As illustrated in FIG. 5, the master BMS 310 may be implemented as one of the plurality of pack BMSs that is designated to perform the role of master BMS. Furthermore, the master BMS 310 may be implemented as hardware located outside the packs, separate from the pack BMSs, and connected to the BMS of each pack.

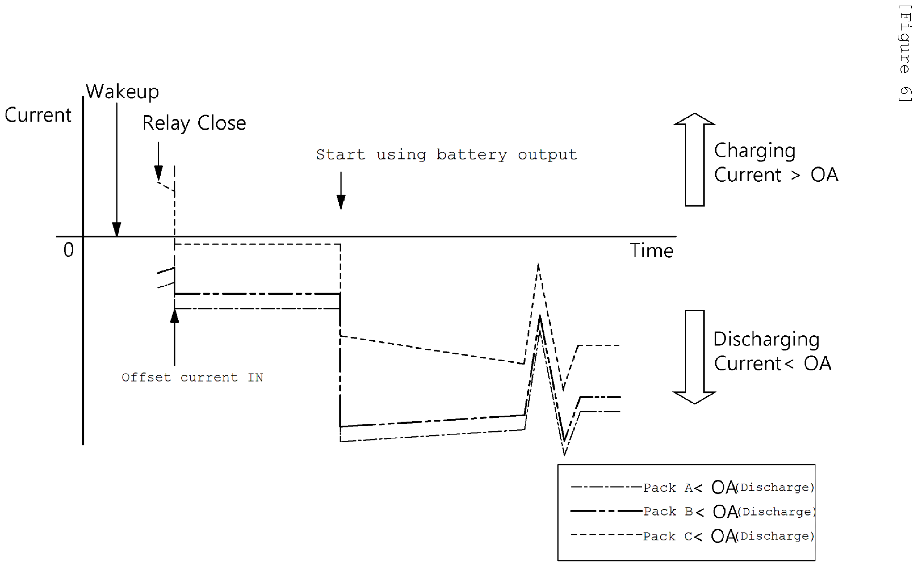

FIG. 6 illustrates the current pattern that can be generated in each pack when an offset current flows in, according to embodiments of the present disclosure.

The embodiment of FIG. 6 assumes that the battery temperature (e.g., -10 degrees Celsius) falls within the allowable discharge temperature range but outside the allowable charge temperature range.

Looking at the current flowing in each battery pack in the graph of FIG. 6, when the battery management apparatus for battery use is turned on and the battery wakes up, the relays for each battery pack close. While the battery packs not yet connected to a load, a negative discharge current flows through Pack 1 and Pack 2 due to the potential difference between the packs, and a positive charge current flows to Pack 3.

According to embodiments of the present disclosure, when the charge current flowing to Battery Pack 3 is detected, the switch of the self-discharge circuit 700 is turned on, allowing an offset current to flow. When the offset current flows, the current flow through Battery Pack 3 changes, causing discharge current to flow through Battery Pack 3 instead of charge current. Since the battery temperature is within the allowable discharge temperature range, no separate safety action, such as the opening of a relay within the pack, occurs. Thus, when the battery system is connected to a load, the discharge outputs of a plurality of battery packs within the battery system can be used normally.

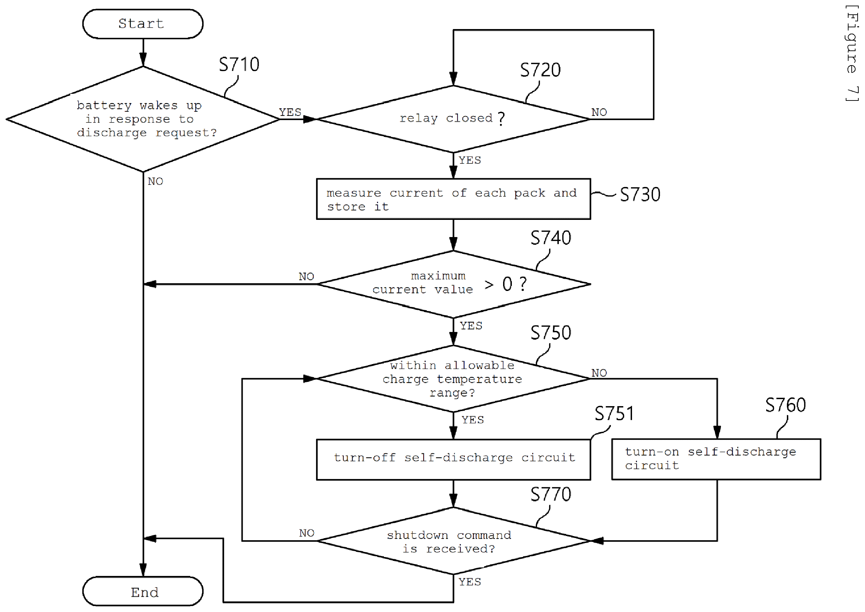

FIG. 7 is a flowchart illustrating battery control operations that can be performed by a battery control apparatus according to embodiments of the present disclosure.

The battery control apparatus according to embodiments of the present disclosure may be included in one of a plurality of pack BMSs in a battery system in which a plurality of battery packs are connected in parallel. Furthermore, the battery control apparatus may be included in a master BMS that monitors and controls a plurality of pack BMSs.

The battery control apparatus may check if a battery pack wakes up (S710) in response to a usage request, e.g., a discharge request, for a battery system including a plurality of battery packs, and check whether the high-voltage relay within each battery pack is switched to a closed state (S720).

Once the high-voltage relay within each battery pack is switched to the closed state, current flows through each pack. The battery control apparatus may measure the current flowing through each pack and store the measured current values (S730).

Thereafter, the battery control apparatus may determine whether the maximum value among the stored current values is positive to determine the direction of the current flowing through the battery pack (S740). A positive current value indicates that charging current is flowing through the corresponding battery pack.

The battery control apparatus may also check whether the temperature of the battery pack is within the allowable charge temperature range (S750). If the temperature of the battery pack is outside the allowable charge temperature range, the battery control apparatus may turn on the self-discharge circuit (S760), which turns on the switch within the self-discharge circuit, generating an offset current for the charging current flowing through the battery pack.

Here, the offset current is a current flowing in the opposite direction to the charging current flowing through the battery pack. Turning on the self-discharge circuit may change the direction of current flowing in the battery pack where the charging current has been flowing, allowing a discharge current to flow through the battery pack, preventing the high-voltage relay of the battery pack from opening. The offset current generated by turning on the self-discharge circuit is equal to the sum of the discharge currents flowing through the plurality of battery packs.

Meanwhile, if the temperature of the battery pack is within the allowable charge temperature range, the self-discharge circuit remains turned off (S751). When a shutdown command is received because battery use is no longer required, battery operation may be terminated (S770).

According to the above-described embodiments of the present disclosure, charging current can be prevented from flowing under a state outside the permissible charge temperature range of a lithium-ion battery.

Furthermore, by resolving the issue of battery system being unusable due to unintended safety actions that can occur due to a mismatch between the allowable discharge temperature range and allowable charge temperature range of the battery, more secure battery usage can be obtained.

The operations of the method according to the embodiments of the present disclosure may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

In addition, the computer-readable recording medium may include hardware devices specially configured to store and execute program instructions, such as ROM, RAM, flash memory, and may include, for example, various types of servers located on a network. The program instructions may include not only machine language codes, such as those created by a compiler, but also high-level language codes that can be executed by a computer using an interpreter.

Although some aspects of the disclosure have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present disclosure has been described with reference to the exemplary embodiment of the present disclosure, but those skilled in the art may appreciate that the present disclosure may be variously corrected and changed within the range without departing from the spirit and the area of the present disclosure described in the appending claims.

## Claims

1. A battery control apparatus for controlling a battery system in which a plurality of battery packs are connected in parallel, the apparatus comprising:
a self-discharge circuit connected in parallel with the plurality of battery packs; and
a controller configured to measure a current flow through each battery pack when each battery pack starts operating in response to a request for use of the plurality of battery packs and to control turning on the self-discharge circuit based on the current flow.

2. The apparatus of claim 1, wherein the controller turns on the self-discharge circuit when a charging current is generated in one or more of the plurality of battery packs while the temperature of the plurality of battery packs is outside an allowable charge temperature range.

3. The apparatus of claim 2, wherein a current, offsetting the charging current, is generated when a switch within the self-discharge circuit is turned on by the controller.

4. The apparatus of claim 3, wherein the current offsetting the charging current is in a direction opposite to the charging current flowing in the one or more of the battery packs.

5. The apparatus of claim 2, wherein, upon turning on the self-discharge circuit, a current flow in at least one of the battery packs is changed to cause a discharging current to flow in the at least one of the battery packs.

6. The apparatus of claim 3, wherein the current offsetting the charging current, which is generated by turning on the self-discharge circuit, is equal to a sum of discharge currents flowing in the plurality of battery packs.

7. The apparatus of claim 1, wherein each battery pack includes:
one or more cell assemblies including a plurality of cells;
a high-voltage relay connected to the one or more cell assemblies; and
a pack battery management apparatus configured to manage the one or more cell assemblies.

8. The apparatus of claim 1, wherein the controller is included in a master battery management apparatus which is connected with a plurality of pack battery management apparatuses for the plurality of battery packs and configured to manage the plurality of pack battery management apparatuses.

9. The apparatus of claim 1, wherein the self-discharge circuit includes:
one or more switches and one or more resistor elements.

10. The apparatus of claim 9, wherein the switches and the resistor elements are connected in series.

11. A method of controlling a battery system in which a plurality of battery packs are connected in parallel, the method comprising:
determining if each battery pack starts operating in response to a request for use of the plurality of battery packs;
measuring a current flow through each battery pack; and
controlling the self-discharge circuit to be turned on based on the current flow.

12. The method of claim 11, wherein controlling the self-discharge circuit to be turned on includes:
turning on the self-discharge circuit when a charging current is generated in one or more of the plurality of battery packs while the temperature of the plurality of battery packs is outside an allowable charge temperature range.

13. The method of claim 12, wherein a current, offsetting the charging current, is generated when a switch within the self-discharge circuit is turned on by the controller.

14. The method of claim 13, wherein the current offsetting the charging current is a current in a direction opposite to the charging current.

15. The method of claim 12, wherein, upon turning on the self-discharge circuit, a current flow in at least one of the battery packs is changed to cause a discharging current to flow in the at least one of the battery packs.

16. The method of claim 13, wherein the current offsetting the charging current, which is generated by turning on the self-discharge circuit, is equal to a sum of discharge currents flowing in the plurality of battery packs.

17. The method of claim 11, wherein each battery pack includes:
one or more cell assemblies including a plurality of cells;
a high-voltage relay connected to the one or more cell assemblies; and
a pack battery management apparatus configured to manage the one or more cell assemblies.

18. The method of claim 13, wherein the self-discharge circuit includes:
one or more switches and one or more resistor elements.

19. The method of claim 18, wherein the switches and the resistor elements are connected in series.

20. The method of claim 11, wherein the controlling of the self-discharge circuit to be turned on based on the current flow includes:
determining whether a maximum value among the measured current values is positive;
determining whether the temperature of one or more of the battery packs is within an allowable charge temperature range; and
turning on the self-discharge circuit if the maximum value is positive and the temperature of one or more of the battery packs is outside the allowable charge temperature range.

21. The method of claim 11, wherein the determining if each battery pack starts operating includes:
determining whether a battery has woken up in response to a request for use of the plurality of battery packs; and
determining whether a relay included in each battery pack has been switched to a closed state.
